# EUROPÄISCHE PATENTSCHRIFT

(11) **EP 3 394 871 B1**
(45) Veröffentlichungstag und Bekanntmachung des Hinweises auf die Patenterteilung: **16.10.2019**
(21) Anmeldenummer: 16798119.0
(22) Anmeldetag: 14.11.2016
(51) Int. Cl.: H01H 13/70, H03K 5/1254, H01H 9/54

(54) **VORRICHTUNG UND VERFAHREN ZUR ERKENNUNG EINER SCHALTERBETÄTIGUNG**
APPARATUS AND METHOD FOR DETECTING ACTUATION OF A SWITCH
DISPOSITIF ET PROCÉDÉ DE DÉTECTION D'UNE OPÉRATION DE COMMUTATION

(30) Priorität: 21.12.2015 DE 102015226315
(43) Veröffentlichungstag der Anmeldung: 31.10.2018
(73) Patentinhaber: Cherry GmbH, 91275 Auerbach/Opf (DE)
(72) Erfinder: KOEFERL, Erwin, 91284 Neuhaus (DE)
(74) Vertreter: Aurigium Leischner & Luthe
(86) Internationale Anmeldenummer: PCT/EP2016/077559
(87) Internationale Veröffentlichungsnummer: WO 2017/108264

(56) Entgegenhaltungen:
- EP-A1- 0 589 655
- EP-A2- 1 643 349
- JP-A- 2002 190 725
- US-A- 4 375 036
- US-A1- 2011 291 799

## Beschreibung

Die Erfindung betrifft eine Vorrichtung mit einer Schaltungsanordnung umfassend zumindest einen mechanischen Schalter, der dazu dient einen elektrischen Kontakt zu öffnen und/oder schließen, und eine Prozessoreinheit, die dazu dient eine erste Abfrage und eine zweite Abfrage eines Kontaktzustandes des Kontakts durchzuführen, wobei die Prozessoreinheit weiterhin dazu dient, ein Ausgangssignal anhand einer Information über eine vermittels der ersten und zweiten Abfragen erkannte Änderung des Kontaktzustands des Kontakts bereitzustellen.

Solche Vorrichtungen kommen häufig im Alltag vor, beispielsweise als Tastaturen oder als Bedienvorrichtungen im Automobil. In bestimmten Anwendungen ist es von Vorteil, wenn die Betätigung eines Schalters schnellstmöglich erkannt und berichtet wird. Bei der Verwendung einer Tastatur, beispielsweise für ein Echtzeit-Strategiespiel, kann es vorkommen, dass ein Kommando schnellstmöglich durch die Betätigung einer der Tasten ausgelöst werden soll. Herkömmlich aber wird die Reaktionszeit eines Schalters bzw. Tastens durch die sogenannte Entprellzeit jedes mechanischen Tastens verzögert. Das heißt beispielsweise, nachdem ein Schalter geschlossen ist, prellt der Kontakt erstmals von dem geschlossenen Zustand zurück in einen offenen Zustand. Innerhalb der ersten fünf bis hundert Millisekunden, je nach Größe und mechanischem Aufbau des Schalters, prellt der Schalter hin und her zwischen offenem und geschlossenem Zustand. Die Zeit bis dieses Prellen aufhört nennt sich im Zusammenhang mit der Erfindung die Entprellzeit.

Bei herkömmlichen Schaltern wird eine Änderung des Kontaktzustandes des Schalters erstmals erkannt, die Entprellzeit abgewartet und dann der Kontaktzustand des Schalters nochmal kontrolliert bevor diese Änderung weiter berichtet wird. Dies führt zu einer Verzögerung zwischen der Betätigung des Schalters und dem Berichten des Schalters, die bei bestimmten Verwendungen als nachteilig angesehen wird.

In der japanischen Offenlegungsschrift JP2002190725 wird ein Verfahren offenbart zur Erkennung des Öffnens oder Schließens eines elektrischen Kontaktes. In diesem Verfahren wird eine Änderung des Kontaktzustandes eines Schalters unmittelbar nachdem die Änderung erkannt ist, weiter berichtet bzw. abgespeichert. Somit wird die Entprellzeit sowie die anschließende Verarbeitung des Schaltsignals umgangen, indem keine Entprellung stattfindet. Das ist insbesondere vorteilhaft, wenn ein langsamer bzw. billiger Prozessor verwendet wird, um das Schaltsignal zu verarbeiten.

In der US Offenlegungsschrift US2011291799 wird ein Schalter und ein Verfahren offenbart, in dem eine Änderung des Kontaktzustandes durch eine erste Abfrage des Kontaktes erkannt wird. Die Entprellzeit wird abgewartet und eine zweite Abfrage des Kontaktes erfolgt, um sicherzustellen, dass eine Änderung tatsächlich passiert ist. Somit kann sichergestellt werden, dass die erste Erkennung einer Änderung des Kontaktzustandes nicht durch eine elektrische Störung beispielsweise entstanden ist. Eine elektrostatische Entladung kann zum Beispiel dazu führen, dass eine Änderung erkannt wird. Durch das Kontrollieren nach der Entprellzeit kann sichergestellt werden, dass der Schalter tatsächlich geschlossen oder geöffnet worden ist.

Es ist daher die Aufgabe der Erfindung eine Vorrichtung und ein Verfahren zur verbesserten Erkennung einer Änderung des Kontaktzustandes eines Kontaktes eines mechanischen Schalters vorzuschlagen.

Die Aufgabe wird gelöst mit einer Vorrichtung gemäß Anspruch 1 sowie mit einem Verfahren gemäß Anspruch 6. Vorteilhafte Weiterbildungen sind Gegenstand der Unteransprüche.

Somit wird die Aufgabe gelöst mit einer Vorrichtung mit einer Schaltungsanordnung umfassend zumindest einen mechanischen Schalter, der dazu dient, einen elektrischen Kontakt zu öffnen und/oder zu schließen, und eine Prozessoreinheit, die dazu dient, eine erste Abfrage und eine zweite Abfrage eines Kontaktzustandes des Kontakts durchzuführen, wobei die Prozessoreinheit weiterhin dazu dient, ein Ausgangssignal anhand einer Information über eine vermittels der ersten und zweiten Abfrage erkannte Änderung des Kontaktzustands des Kontakts bereitzustellen, wobei die Prozessoreinheit ausgestaltet ist, die zweite Abfrage nach der ersten Abfrage zeitlich so durchzuführen, dass die zweite Abfrage einer zu erwartenden Prellung des Kontakts vorausgeht. Somit kann eine fehlerhafte Erkennung, also eine Änderung des Kontaktzustandes, die beispielsweise durch eine elektrostatische Entladung vorkommt, ausgeschlossen werden.

Der Kontaktzustand wird zweimal abgefragt. Eine Abfrage kann beispielsweise erfolgen, indem die Prozessoreinheit die Spannung eines Erfassungsstromkreises des Kontakts abtastet. Die erste Abfrage kann beispielsweise in einem normalen Abfragezyklus der Prozessoreinheit passieren. Die Prozessoreinheit führt dabei eine regelmäßige Abfrage des Kontaktzustandes durch. Wenn die Prozessoreinheit eine Änderung des Kontaktzustandes erkennt, kann die Prozessoreinheit die Abfrage von anderen Kontakten oder anderen Prozessen unterbrechen, um eine zweite Abfrage des Kontaktes durchzuführen. Die Prozessoreinheit ist dazu ausgelegt, die zweite Abfrage in wenigen Nanosekunden nach der ersten Abfrage durchzuführen, beispielsweise 47 Nanosekunden. Die Zeitverzögerung zwischen der ersten und der zweiten Abfrage ist lang genug, um den Einfluss einer elektrostatischen Entladung auszuschließen. Die Zeitverzögerung zwischen der ersten und der zweiten Abfrage ist weiterhin so kurz gehalten, dass eine erwartete erste Prellung nicht erst passieren kann.

In einer vorteilhaften Ausgestaltung ist die Prozessoreinheit dazu ausgelegt die zweite Abfrage unmittelbar nach der ersten Abfrage durchzuführen. Die Prozessoreinheit führt in der Regel verschiedene Prozesse durch. Unmittelbar im Sinne der Erfindung heißt, dass die Prozessoreinheit die Reihenfolge der durchzuführenden Prozesse ändert, so dass die zweite Abfrage als allernächstes drankommt.

Die Prozessoreinheit kann dazu ausgelegt sein, das Ausgangssignal unmittelbar nach der zweiten Abfrage bereitzustellen. Das Bereitstellen des Ausgangssignals heißt beispielsweise, dass die Prozessoreinheit ein Datenpaket in einem Puffer ablegt, wobei diese Datenpakete weiterhin von einem Datenübertragungsprotokoll abgeholt werden. Dem Ausgangssignal kann beispielsweise Vorrang gegeben werden. Das Berichten der Änderung des Kontaktzustandes bzw. das Abholen des Datenpakets kann somit zum nächstmöglichen Zeitpunkt ermöglicht werden.

In einer Ausgestaltung der Erfindung ist die Prozessoreinheit dazu ausgelegt, eine weitere Änderung des Kontaktzustandes erst mit dem Ablauf einer vorgegebenen Entprellzeit des Kontaktes zu erkennen. Somit, beispielsweise, fragt die Prozessoreinheit den Kontaktzustand des Kontaktes bis die Entprellzeit zu Ende ist nicht ab. Ebenfalls ist es während der Entprellzeit möglich, dass die Prozessoreinheit den Kontaktzustand abfragt, aber keine Änderung des Kontaktzustandes anerkennt bzw. berücksichtigt, bis die Entprellzeit vorbei ist. Es wird somit sichergestellt, dass Prellungen, die zwangsläufig nach der ersten und zweiten Abfragung auftreten, nicht mit einer Betätigung des Schalters verwechselt werden und somit nicht als Ursache eines Ausgangssignals dienen würden.

Gemäß einer Weiterbildung der Erfindung weist die Vorrichtung mehrere mechanische Schalter auf, wobei die mechanischen Schalter als Tasten in einer Tastatur ausgestaltet sind.

In einer Ausgestaltung der Erfindung in der die Vorrichtung mehr als einen mechanischen Schalter aufweist.

In einer Weiterbildung ist die Prozessoreinheit dazu ausgelegt eine zweite Abfrage eines ersten Schalters durchzuführen vor der Durchführung einer ersten Abfrage eines zweiten Schalters. Mit der Erkennung einer Änderung des Kontaktzustandes eines ersten Schalters priorisiert die Prozessoreinheit die zweite Abfrage des ersten Schalters und somit wird erst nach der Durchführung einer ersten und zweiten Abfrage eines ersten Schalters eine erste Abfrage eines zweiten Schalters durchgeführt.

Die Aufgabe wird weiterhin gelöst durch ein Verfahren gemäß Anspruch 7.

Somit wird die Aufgabe gelöst mit einem Verfahren zur Erkennung einer Änderung eines Kontaktzustandes eines Kontakts eines mechanischen Schalters, wobei der Kontakt geöffnet und/oder geschlossen wird, wobei eine erste Abfrage und eine zweite Abfrage eines Kontaktzustandes des Kontakts durchgeführt werden, wobei ein Ausgangssignal anhand einer Information über eine vermittels der ersten und zweiten Abfragen erkannte Änderung des Kontaktzustands des Kontakts bereitgestellt wird, wobei die zweite Abfrage nach der ersten Abfrage zeitlich so durchgeführt wird, dass die zweite Abfrage einer zu erwartenden Prellung des Kontakts vorausgeht. In anderen Worten, wenn bei einer ersten Abfrage des Kontaktzustandes des Kontakts die Änderung des Kontaktzustands des Kontakts erkannt wird, dann wird eine zweite Abfrage des Kontaktzustands innerhalb einer bestimmten Zeitdauer durchgeführt. Der bestimmten Zeitdauer kann beispielsweise eine Zeitspanne zwischen dem Öffnen und/oder Schließen des Kontakts und einer ersten Prellung des Kontakts entsprechen, wenn die Änderung sofort erkannt wird.

Die Erfindung wird im Folgenden anhand der folgenden Figuren näher erläutert. Diese zeigen:
- Figur 1: eine Ausgestaltung der Vorrichtung, indem die mechanischen Schalter als Tasten in einer Tastatur ausgestaltet sind;
- Figur 2: eine schematische Darstellung einer Ausgestaltung der Vorrichtung;
- Figur 3: eine grafische Darstellung eines Schaltsignals eines mechanischen Schalters; und
- Figur 4: ein Flussdiagramm eines Verfahrensablaufs gemäß einer Ausgestaltung der Erfindung.

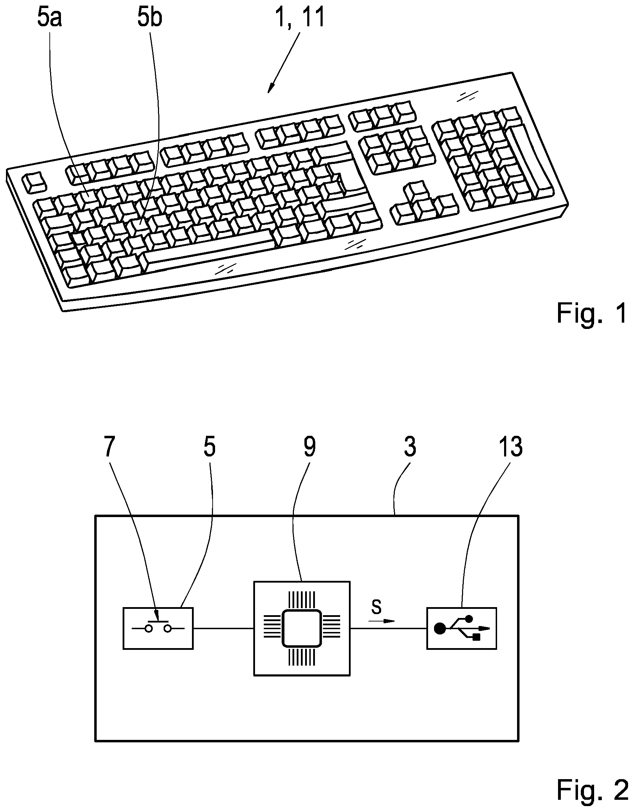

Fig. 1 zeigt eine Ausgestaltung der Vorrichtung, indem die mechanischen Schalter 5 als Tasten 5 in einer Tastatur 11 ausgestaltet sind. In einer solchen Tastatur 11, wenn einer der Schalter 5 bzw. Tasten 5 gedrückt wird, wird ein elektrischer Kontakt 7 entweder geschlossen oder geöffnet. Ebenfalls wenn die Taste 5 wieder losgelassen wird, wird der Kontakt 7 entsprechend geöffnet oder geschlossen. Das Öffnen und Schließen solcher mechanischer Tasten 5 wird immer von einem Prellverhalten begleitet. Das heißt, dass beispielsweise wenn eine Taste 5 gedrückt wird, dass ein Kontakt 7 geschlossen wird und springt aber eine Zeitlang zwischen geschlossenem und offenem Zustand 1/0. Die Zeit, in der der elektrische Kontakt 7 prellt, nennt sich die Entprellzeit Tp. Während der Entprellzeit Tp kann sich in jedem Moment eine Abfrage A1 des Kontaktes 7 ergeben, dass der Kontaktzustand 1/0 entweder offen ist oder geschlossen ist. Herkömmlich wurden die Unsicherheiten, die dieses Prellverhalten mit sich bringt, umgangen, indem der Kontakt 7 ein zweites Mal abgefragt A2 wird, nachdem die Entprellzeit Tp vorbei ist. Allerdings führt das zu einer Verzögerung zwischen dem Betätigen T0 der Tasten 5 und dem Zeitpunkt, zu dem die Änderung des Kontaktzustandes1/0, die durch dieses Betätigen T0 verursacht wird, weiter berichtet wird. Diese Verzögerung kann eliminiert werden, indem der Kontakt 7 ein zweites Mal abgefragt A2 wird sofort nachdem eine Änderung erkannt worden ist. Somit kann die Geschwindigkeit der Tastatur 11 erhöht werden. Beispielsweise, anstatt einer 10 Millisekunde Verzögerung zwischen Betätigung T0 und Berichten kann eine Tastatur 11, die so ausgestaltet ist, innerhalb von 1 Millisekunde nach der Betätigung der Taste 5 berichten.

Fig. 2 zeigt eine schematische Darstellung einer Ausgestaltung der Vorrichtung 1 mit einem mechanischen Schalter 5 einer Prozessoreinheit 9 sowie einer USB-Anschlussstelle 13. Die Prozessoreinheit 9 dient dazu, den elektrischen Kontakt 7 in dem mechanischen Schalter 5 regelmäßig abzufragen bzw. abzutasten. Beispielsweise kontrolliert die Prozessoreinheit 9 den Kontaktzustand 1/0 des Kontakts 7 einmal pro Millisekunde. Das Ergebnis der Abfrage A1 kann von der Prozessoreinheit 9 abgelegt bzw. gespeichert werden. Die Prozessoreinheit kann beispielsweise ein Cortex M0 32 Bit Prozessor mit 16 Bit Speicher sein. Sollte das Ergebnis der Abfrage A1 zeigen, dass eine Änderung des Kontaktzustandes 1/0 stattgefunden hat, wird die Reihenfolge der anstehenden Prozesse in der Prozessoreinheit 9 vertauscht, sodass als nächstes eine zweite Abfrage A2 des Kontaktzustandes 1/0 des Kontaktes 7 stattfindet bzw. durchgeführt wird. Die zweite Abfrage A2 passiert dann in der Zeit, nach dem ersten Erkennen einer Zustandsänderung aber bevor eine erste Prellung P des Kontaktes 7 stattfinden kann. Um sicherzustellen, dass genügend Zeit übrig ist, die zweite Abfrage A2 durchzuführen, kann die Zeitdauer zwischen regelmäßigen Abfragen A1 von Prozessoreinheiten 9 am Kontakt 7 geringer gehalten werden, als die Zeit zwischen einer Betätigung T0 und einer ersten Prellung P. Wenn die Änderung des Kontaktzustandes 1/0 durch die zweite Abfrage A2 bestätigt wird, vertauscht die Prozessoreinheit 9 ein zweites Mal die Reihenfolge der anstehenden Prozesse, sodass diese Änderung schnellstmöglich berichtet wird. Das Berichten findet über ein Ausgangssignal S statt, das beispielsweise als Datenpaket S in dem USB-Puffer zur Ausgabe über der USB-Anschlussstelle abgelegt wird.

In dem USB-Protokoll werden Daten regelmäßig abgeholt, dabei gilt, mit jedem Zyklus des USB-Protokolls wird eine bestimmte Menge an Daten abgeholt. Somit, um sicherzustellen, dass das Datenpaket S mit den Informationen über die Änderung des Kontaktzustandes 1/0 im nächsten USB-Zyklus abgeholt wird, wird dem Ausgangssignal S bzw. dem Datenpaket S im Puffer Vorrang gegeben. Es ist daher möglich, dass die Vorrichtung 1 eine Änderung des Kontaktzustandes 1/0 innerhalb von 1 Millisekunde nach dem Betätigen T0 des Schalters 5 berichten kann. Dies stellt eine zehnfache Verbesserung über herkömmliche Schalter 5 bzw. Tastaturen 11 dar, welche in der Regel 10 Millisekunden oder länger benötigen, um eine Änderung des Kontaktzustandes 1/0 zu berichten.

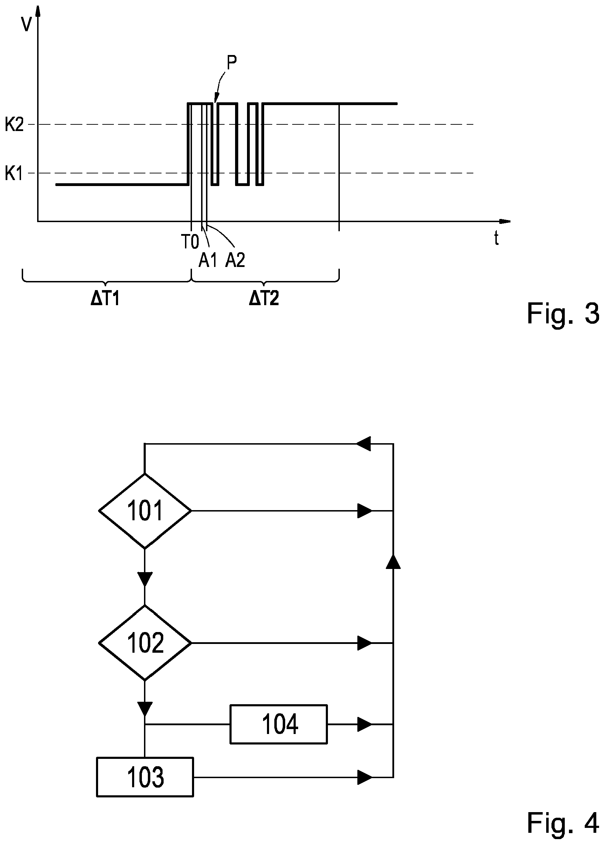

Fig. 3 zeigt eine grafische Darstellung eines Schaltsignals eines mechanischen Schalters 5. Insbesondere wird ein Spannungsverlauf eines Schaltsignals über Zeit dargestellt. In einem ersten Zeitabschnitt ΔT1 verläuft die Spannung V des Signals unter einem ersten Schwellwert K1. Plötzlich, bei der Betätigung T0 des Schalters 5 springt die Spannung V über einen zweiten Schwellwert K2. Der Kontakt 7 wird regelmäßig abgefragt bzw. die Spannung V des Schaltsignals wird regelmäßig abgetastet von der Prozessoreinheit 9. Zu einem ersten Zeitpunkt A1 wird der Kontakt 7 zum ersten Mal abgefragt. Die Prozessoreinheit 9 erkennt dabei eine Änderung des Kontaktzustandes 1/0. Die Prozessoreinheit 9 führt sofort danach eine zweite Abfrage A2 des Kontaktes 7 durch. Die zweite Abfrage A2 findet statt in einem Zeitraum bevor eine erste Prellung P des Kontaktsignals erfolgen kann. Somit wird gleichzeitig vermieden, dass eine elektromagnetische Störung eine Fälschung einer Änderung des Kontaktzustandes 1/0 erzeugen kann, und die Bedingung, dass die Entstörzeit bzw. Entprellzeit Tp abgewartet wird bevor eine zweite Abfrage A2 durchgeführt wird, wird erhoben. Es ist allerdings trotzdem nötig, die Möglichkeit auszuschließen, dass die Prellungen P des Kontaktes 7 als eine Änderung des Kontaktzustandes 1/0 von offen zu geschlossen bzw. geschlossen zu offen anerkannt werden. Dies erfolgt, indem die Prozessoreinheit 9 eine vorgegebene Zeitperiode ΔT2 abwartet. Diese Zeitperiode ΔT2 kann beispielsweise zwei Mal die zu erwartende Entprellzeit Tp betragen. Somit wird der Kontakt 9 in dieser Zeitperiode ΔT2 entweder nicht abgetastet bzw. nicht abgefragt oder die Ergebnisse der regelmäßigen Abfragen A1 des Kontaktes 7 werden in der Prozessoreinheit 9 verworfen. Um einen Anfang der Laufzeit der Zeitperiode bzw. Rucksackzeit ΔT2 aufzuzeichnen, kann die Prozessoreinheit einen Zeitstempel mit der ersten oder zweiten Abfrage in einen Speicher hinterlegen.

Fig. 4 zeigt ein Flussdiagramm eines Verfahrens gemäß einer Ausgestaltung der Erfindung. In einem ersten Schritt 101 wird eine Abfrage A1 des Kontaktes 7 durchgeführt.

Wird eine Änderung des Kontaktzustandes 1/0 erkannt, wird in einem zweiten Schritt 102 eine zweite Abfrage A2 des Kontaktes 7 durchgeführt. Wenn keine Änderungen erkannt werden, fängt das Verfahren wieder mit dem ersten Schritt 101 an. Wenn in dem zweiten Schritt 102 keine Änderungen gegenüber des ursprüngliches Kontaktzustands 1/0 erkannt werden, fängt das Verfahren ebenfalls von vorne mit dem ersten Schritt 101 wieder an. Wenn im zweiten Schritt 102 die Änderung des Kontaktzustandes 1/0, die im ersten Schritt 101 erkannt wurde, bestätigt wird, werden gleichzeitig zwei Prozesse ausgelöst. Ein erster Prozess in einem dritten Schritt 103 wird die Änderung des Kontaktzustandes 1/0 berichtet bzw. bereitgestellt. Ein zweiter Prozess, der in einem vierten Schritt 104 ausgelöst wird, wird einen Zeitstempel gesetzt, die den Anfang einer Zeitperiode ΔT2 markiert, in der keine weitere Änderung des Kontaktzustandes 1/0 anerkannt wird.

### Bezugszeichen

- 1: Vorrichtung
- 3: Schaltungsanordnung
- 5: Schalter bzw. Taste
- 7: Kontakt
- 9: Prozessoreinheit
- 11: Tastatur
- 13: USB-Anschlussstelle
- P: Prellung
- Tp: Entprellzeit
- A1: erste Abfrage
- A2: zweite Abfrage
- 5a,5b: erster, zweiter Schalter
- 1/0: Kontaktzustand des Kontakts
- S: Ausgangssignal
- ΔT1: erster Zeitabschnitt
- ΔT2: Zeitperiode
- V: Spannung
- K1: erster Schwellwert
- K2: zweiter Schwellwert

## Patentansprüche

1. Vorrichtung (1) mit einer Schaltungsanordnung (3) umfassend zumindest einen mechanischen Schalter (5), der dazu dient, einen elektrischen Kontakt (7) zu öffnen und/oder zu schließen, und eine Prozessoreinheit (9), die dazu dient, eine erste Abfrage (A1) und eine zweite Abfrage (A2) eines Kontaktzustandes (1/0) des Kontakts (7) durchzuführen, wobei die Prozessoreinheit (9) weiterhin dazu dient, ein Ausgangssignal (S) anhand einer Information über eine vermittels der ersten und zweiten Abfragen (A1, A2) erkannte Änderung des Kontaktzustands (1/0) des Kontakts (7) bereitzustellen, **dadurch gekennzeichnet, dass** die Prozessoreinheit (9) ausgestaltet ist, die zweite Abfrage (A2) nach der ersten Abfrage (A1) zeitlich so durchzuführen, dass die zweite Abfrage (A2) einer zu erwartenden Prellung (P) des Kontakts (7) vorausgeht.

2. Vorrichtung (1) nach Anspruch 1, **dadurch gekennzeichnet, dass** die Prozessoreinheit (9) dazu ausgelegt ist, die zweite Abfrage (A2) als allernächstes nach der ersten Abfrage (A1) durchzuführen.

3. Vorrichtung (1) nach zumindest einem der vorhergehenden Ansprüche, **dadurch gekennzeichnet, dass** die Prozessoreinheit (9) dazu ausgelegt ist, eine weitere Änderung des Kontaktzustands (1/0) erst mit dem Ablauf einer vorgegebenen Entprellzeit (Tp) des Kontakts zu erkennen.

4. Vorrichtung (1) nach zumindest einem der vorhergehenden Ansprüche, **dadurch gekennzeichnet, dass** die Vorrichtung (1) mehrere mechanische Schalter (5) aufweist, wobei der mechanische Schalter (5) als Tasten (5) in einer Tastatur (11) ausgestaltet sind.

5. Vorrichtung (1) nach zumindest einem der vorhergehenden Ansprüche, **dadurch gekennzeichnet, dass**, wenn die Vorrichtung (1) mehr als einen mechanischen Schalter (5) aufweist, die Prozessoreinheit (9) dazu ausgelegt ist, eine zweite Abfrage (A2) eines ersten Schalters (5a) vor der Durchführung einer ersten Abfrage (B1) eines zweiten Schalters (5b) durchzuführen.

6. Verfahren zur Erkennung einer Änderung eines Kontaktzustandes (1/0) eines Kontakts (7) eines mechanischen Schalters (5), wobei der Kontakt (7) geöffnet und/oder geschlossen wird, wobei eine erste Abfrage (A1) und eine zweite Abfrage (A2) eines Kontaktzustandes (1/0) des Kontakts (7) durchgeführt werden, wobei ein Ausgangssignal (S) anhand einer Information über eine vermittels der ersten und zweiten Abfragen (A1, A2) erkannte Änderung des Kontaktzustands (1/0) des Kontakts (7) bereitgestellt wird, **dadurch gekennzeichnet, dass** die zweite Abfrage (A2) nach der ersten Abfrage (A1) zeitlich so durchgeführt wird, dass die zweite Abfrage (A2) einer zu erwartenden Prellung (P) des Kontakts (7) vorausgeht.

## Claims

1. Apparatus (1) with circuitry (3) comprising at least one mechanical switch (5) serving to open and/or close an electric contact (7) and a processor unit (9) serving to perform first query (A1) and a second query (A2) of a contact state (1/0) of the contact (7), with the processor unit (9) further serving to provide an output signal (S) on the basis of information on a change of the contact state (1/0) of the contact (7) detected by means of the first and second queries (A1, A2), **characterized in that** the processor unit (9) is configured to perform the second query (A2) after the first query (A1) with a timing so that the second query (A2) precedes an expected bounce (P) of the contact (7).

2. Apparatus (1) according to claim 1, **characterized in that** the processor unit (9) is configured to perform the second query (A2) as the very next one after the first query (A1).

3. Apparatus (1) according to at least one of the preceding claims, **characterized in that** the processor unit (9) is configured to detect another change the contact state (1/0) only when a default debounce time (Tp) of the contact has lapsed.

4. Apparatus (1) according to at least one of the preceding claims, **characterized in that** the apparatus (1) comprises several mechanical switches (5), wherein the mechanical switch (5) are implemented as keys (5) in a keyboard (11).

5. Apparatus (1) according to at least one of the preceding claims, **characterized in that** if the apparatus (1) comprises more than one mechanical switch (5), the processor unit (9) is configured to perform a second query (A2) of a first switch (5a) before performing a first query (B1) of a second switch (5b).

6. Method of detecting change of a contact state (1/0) of a contact (7) a mechanical switch (5), wherein the contact (7) is opened and/or closed, wherein a first query (A1) and a second query (A2) of a contact state (1/0) of the contact (7) are performed, wherein an output signal (S) is provided on the basis of information on a change of the contact state (1/0) of the contact (7) detected by means of the first and second queries (A1, A2), **characterized in that** the second query (A2) is performed after the first query (A1) with a timing so that the second query (A2) precedes an expected bounce (P) of the contact (7).

## Revendications

1. Dispositif (1) pourvu d'un circuit (3) qui comporte au moins un commutateur mécanique (5) servant à ouvrir et/ou fermer un contact électrique (7), et une unité de traitement (9) servant à effectuer une première interrogation (A1) et une deuxième interrogation (A2) d'un état (1/0) du contact (7), l'unité de traitement (9) servant en outre à produire un signal de sortie (S) sur la base d'une information concernant une modification de l'état (1/0) du contact (7) qui est détectée au moyen des première et deuxième interrogations (A1, A2), **caractérisé en ce que** l'unité de traitement (9) est conçue pour exécuter dans le temps la deuxième interrogation (A2) après la première interrogation (A1) de manière à ce que la deuxième interrogation (A2) précède un rebond attendu (P) du contact (7).

2. Dispositif (1) selon la revendication 1, **caractérisé en ce que** l'unité de traitement (9) est conçue pour effectuer la deuxième interrogation (A2) de manière à ce qu'elle soit la plus proche après la première interrogation (A1).

3. Dispositif (1) selon l'une au moins des revendications précédentes, **caractérisé en ce que** l'unité de traitement (9) est conçue pour détecter une modification supplémentaire de l'état (1/0) du contact uniquement à l'expiration d'un temps de réponse (Tp) prédéterminé du contact.

4. Dispositif (1) selon l'une au moins des revendications précédentes, **caractérisé en ce que** le dispositif (1) comporte une pluralité de commutateurs mécaniques (5), les commutateurs mécaniques (5) étant conçus comme des touches (5) d'un clavier (11).

5. Dispositif (1) selon l'une au moins des revendications précédentes, **caractérisé en ce que**, lorsque le dispositif (1) comprend plus d'un commutateur mécanique (5), l'unité de traitement (9) est conçue pour effectuer une deuxième interrogation (A2) d'un premier commutateur (5a) avant d'effectuer une première interrogation (B1) d'un deuxième commutateur (5b).

6. Procédé de détection d'une modification d'état (1/0) d'un contact (7) d'un commutateur mécanique (5), le contact (7) étant ouvert et/ou fermé, une première interrogation (A1) et une deuxième interrogation (A2) d'un état (1/0) du contact (7) étant effectuées, un signal de sortie (S) étant produit sur la base d'une information concernant une modification de l'état (1/0) du contact (7) détectée au moyen des première et deuxième interrogations (A1, A2), **caractérisé en ce que** la deuxième interrogation (A2) est effectuée dans le temps après la première interrogation (A1) de sorte que la deuxième interrogation (A2) précède un rebond attendu (P) du contact (7).
